# EUROPÄISCHE PATENTSCHRIFT

(11) **EP 2 284 855 B1**
(45) Veröffentlichungstag und Bekanntmachung des Hinweises auf die Patenterteilung: **29.03.2017**
(21) Anmeldenummer: 09167530.6
(22) Anmeldetag: 10.08.2009
(51) Int. Cl.: H01H 33/66, G01R 31/327, B60L 9/00

(54) **Verfahren zur Funktionsprüfung eines Vakuumschalters eines Traktionsstromrichters**
Method for function testing a vacuum switch of a traction inverter
Procédé de contrôle du fonctionnement d'un interrupteur à vide d'un convertisseur de courant à traction

(43) Veröffentlichungstag der Anmeldung: 16.02.2011
(73) Patentinhaber: Siemens Aktiengesellschaft, 80333 München (DE)
(72) Erfinder: Lang, Norbert, 90763 Fürth (DE)

(56) Entgegenhaltungen:
- DE-A1- 3 643 672
- DE-A1- 19 526 435
- GB-A- 2 203 559
- JP-A- 8 308 252

## Beschreibung

Die Erfindung bezieht sich auf ein Verfahren zur Funktionsprüfung eines Vakuumschalters eines Traktionsstromrichters.

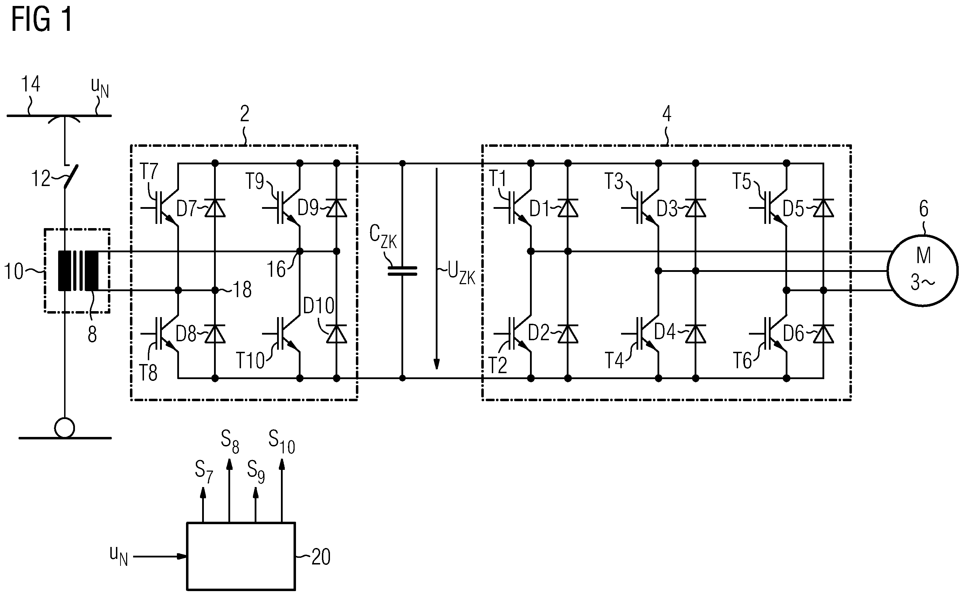

Ein derartiger Traktionsstromrichter ist in der FIG 1 näher dargestellt. Dieser Traktionsstromrichter weist netzseitig einen Vierquadrantensteller 2 und lastseitig einen selbstgeführten Stromrichter 4, der auch als Pulsstromrichter bezeichnet wird, auf, die gleichspannungsseitig mittels eines Zwischenkreiskondensators C_{ZK} elektrisch parallel geschaltet sind. An den Ausgängen des Pulsstromrichters 4 ist ein Drehstrommotor 6 angeschlossen. Der Vierquadrantensteller 2 ist wechselspannungsseitig mittels einer Sekundärwicklung 8 eines Traktionstransformators 10 und eines Vakuumschalters 12 mit einem Fahrdraht 14 elektrisch leitend verbindbar. Jeweils ein Anschluss der Sekundärwicklung 8 des Traktionstransformators 10 ist mit einem Wechselspannungs-Anschluss 16 bzw. 18 des Vierquadrantenstellers 2 elektrisch leitend verbunden. Mittels diesem Vierquadrantensteller 2 wird eine einphasige Netz-Wechselspannung u_{N} in eine vorbestimmte Zwischenkreis-Gleichspannung U_{ZK} umgeformt, aus der dann ein an die Bedürfnisse des Drehstrommotors 6 angepasstes Spannungssystem, beispielsweise ein Drehspannungssystem variabler Amplitude und Frequenz generiert wird.

In dieser bekannten Ausführungsform des Traktionsstromrichters werden als Stromrichterventile T1 bis T6 des selbstgeführten Stromrichters 4 und als Stromrichter T7 bis T10 des Vierquadrantenstellers 2 jeweils abschaltbare Leistungshalbleiterschalter, insbesondere **I**nsulated-**G**ate-**B**ipolar-**T**ransistoren (IGBT), verwendet. Jeden abschaltbaren Leistungshalbleiterschalter T1 bis T6 bzw. T7 bis T10 ist eine Leistungsdiode D1 bis D6 bzw. D7 bis D10 elektrisch parallel geschaltet.

Die für die Umrichterauslegung relevante Leistungsflussrichtung ist vom speisenden Netz über den Fahrdraht 14 und den Traktionstransformator 10, den Vierquadrantensteller 2 und den selbstgeführten Stromrichter 4 zum Drehstrommotor 6. Zur Steuerung der Stromrichterventile T7 bis T10 des Vierquadrantenstellers 2 ist eine Regelungseinrichtung 20 vorgesehen, der die einphasige Netz-Wechselspannung u_{N} zugeführt ist. Als Regelungseinrichtung 20 kann beispielsweise ein Microcontroler vorgesehen sein, der in der Steuer- und Regeleinrichtung des Traktionsstromrichters untergebracht ist.

Ein der FIG 1 dargestellter Traktionsstromrichter ist aus der Veröffentlichung mit dem Titel "Comparison of Multi-System Traction Converters for High-Power Locomotives" PESC-Konferenz 2004 vom 21.06. bis 23.06.2004 in Aachen, insbesondere der Figur 10 dieser Veröffentlichung, bekannt. Wird netzseitig Wert auf einen geringen Oberschwingungsanteil des Netzstromes gelegt, so wird netzseitig zwei Vierquadrantensteller vorgesehen, die jeweils über eine Transformator-Sekundärwicklung netzseitig parallel geschaltet sind und auf einen gemeinsamen Gleichspannungs-Zwischenkreis arbeiten. Die Steuerung dieser beiden Vierquadrantensteller erfolgt durch phasenversetzes Takten der beiden Vierquadrantensteller. Dadurch wird erreicht, dass die Oberschwingungen der Netzströme auf der Sekundärseite um 180° elektrisch gegeneinander verschoben sind und sich damit auf der Primärseite des Traktionstransformators durch Summenbildung weitgehend kompensieren. Ein derartiger Traktionsstromrichter ist ebenfalls aus der vorgenannten Veröffentlichung, insbesondere der Figur 8 bzw. Figur 12 dieser Veröffentlichung, bekannt.

Der Vakuumschalter 12 ist ein Leistungsschalter 12, der für hohe Ströme ausgelegt ist. Dieser kann nicht nur Betriebsströme einschalten, sondern auch bei Fehlern hohe Überlastströme und Kurzschlussströme für eine vorgegebene Zeit halten und ausschalten. Beim Vakuumschalter befinden sich seine Kontakte zur Vermeidung eines Lichtbogens unter Vakuum. Diese Vakuumschalter werden vorwiegend nur bei Mittelspannungsanlagen mit Spannungen bis ca. 40kV eingesetzt und sind für sehr große Schalthäufigkeiten bei weitestgehender Wartungsfreiheit geeignet. Dieser Vakuumschalter kann durch spontanen oder schleichenden Verlust des Vakuums seine Funktionsfähigkeit verlieren. In Folge eines derartigen funktionslosen Vakuumschalters kann im Fehlerfall der gesamte Traktionsstromrichter in Mitleidenschaft gezogen werden.

Um die Funktionstüchtigkeit eines derartigen Vakuumschalters überprüfen zu können, wird bekannterweise ein Prüfgerät verwendet. Der Vakuumschalter des Traktionsstromrichters muss dafür von der Hochspannungsausrüstung getrennt werden und das Prüfgerät angeschlossen werden. Bekannte Prüfgeräte arbeiten mit einer Prüfspannung von mehreren Kilovolt und müssen mit einem Hochspannungstransformator und einer entsprechend ausgelegten Isolation ausgerüstet sein. Außerdem sind bei der Prüfung selbst umfangreiche Vorsichtsmaßnahmen zu beachten. Die Arbeitsweise der bekannten Prüfeinrichtung sieht vor, dass die Vakuumkammer mit einer Prüfspannung getestet wird, die zwischen Durchschlagsspannung bei vollem Vakuum und der Durchschlagsspannung von Luft bei atmosphärischem Druck liegt. Diese Prüfspannung wird an den geöffneten Schaltkontakten angelegt und die innere Durchschlagsspannung bestimmt. Auf diese Weise wird festgestellt, ob die geprüfte Vakuumkammer noch über ein ausreichendes Vakuum verfügt.

Diese Prüfung des Vakuumschalters bedeutet Aufwand und Stillstandszeiten des Traktionsantriebs. Unterbleibt die Prüfung, kann ein Versagen des Vakuumschalters hohe Folgeschäden nach sich ziehen. Da für die Funktionsprüfung des Vakuumschalters ein Prüfgerät benutzt werden muss, kann diese Funktionsprüfung nur in einem Eisenbahn- bzw. Straßenbahndepot vorgenommen werden.

Als Stand der Technik sind JP408308252 und GB2203559 bekannt.

Der Erfindung liegt nun die Aufgabe zugrunde, ein Verfahren zur Funktionsprüfung des Vakuumschalters eines Traktionsstromrichters anzugeben, wodurch auf die Verwendung eines Prüfgerätes verzichtet werden kann.

Diese Aufgabe wird mit den Verfahrensschritten nach Anspruch 1 erfindungsgemäß gelöst.

Das erfindungsgemäße Verfahren besteht darin, dass bei geöffneten Vakuumschalter der Vierquadrantensteller derart angesteuert wird, dass dieser als Stellerspannung einen Spannungspuls generiert, dessen zeitliche Lage relativ zur umlaufenden Netz-Wechselspannung derart eingestellt wird, dass eine vorbestimmte Prüfspannung am Vakuumschalter abfällt. Ist die Isolationsfähigkeit des Vakuumschalters nicht gegeben, fließt ein Strom vom speisenden Netz zum Vierquadrantensteller, der von einer Messwerterfassung des Vierquadrantenstellers erfasst wird. Ist der Vakuumschalter funktionstüchtig, kann kein Stromfluss festgestellt werden. Zur Generierung eines derartigen Spannungspulses wird die Energie des Zwischenkreiskondensators des Spannungszwischenkreises des Traktionsstromrichters verwendet.

Der Vorteil des erfindungsgemäßen Verfahrens zur Funktionsprüfung eines Vakuumschalters eines Traktionsstromrichters besteht darin, dass kein Prüfgerät mehr verwendet werden muss. D.h., mittels der vorhandenen Schaltungsteile eines Traktionsstromrichters kann die Funktionsprüfung durchgeführt werden. Ein weiterer Vorteil besteht darin, dass der Vakuumschalter nicht mehr von der Hochspannungsausrüstung getrennt werden muss. Somit kann an jedem Ort zu jeder Zeit diese Funktionsprüfung des Vakuumschalters eines Traktionsstromrichters durchgeführt werden. Die Funktionsprüfung kann automatisch ablaufen. Wegen des geringen Aufwands der Funktionsprüfung des Vakuumschalters eines Traktionsstromrichters vereinfacht und verbessert sich die Fehleroffenbarung wesentlich.

Zur näheren Erläuterung der Erfindung wird auf die Zeichnung Bezug genommen, mit der die Funktionsweise des erfindungsgemäßen Verfahrens näher erläutert wird.
- FIG 1: zeigt eine bekannte Ausführungsform eines Traktionsstromrichters, wobei in der
- FIG 2: ein zugehöriges einphasiges Ersatzschaltbild für netzseitig Spannungen und Ströme dargestellt ist.

Dieses einphasige Ersatzschaltbild weist eine Spannungsquelle 22 und eine Spannungsquelle 24 auf, die elektrisch parallel geschaltet sind. Die Spannungsquelle 22 ersetzt das speisende Netz, wobei die Spannungsquelle 24 den Vierquadrantensteller 2 mit gleichspannungsseitigem Zwischenkreis-Kondensator C_{ZK} ersatzweise darstellt. Vom Traktionstransformator 10 erscheint im einphasigen Ersatzschaltbild nur seine Streuinduktivität 26. Der offene Vakuumschalter 12 wird im Ersatzschaltbild als Funkstrecke 28 dargestellt. Während des Betriebes des Traktionsstromrichters ist der Vakuumschalter 12 geschlossen, so dass die beiden Spannungsquellen 22 und 24 mittels der Streuinduktivität des Traktionstransformators 10 elektrisch parallel geschaltet sind. Gemäß diesem Ersatzschaltbild im Normalbetrieb sind Netz-Wechselspannung u_{N} und Stellereingangsspannung u_{St} um einen Winkel zueinander phasenverschoben. Mit steigender Stellertaktfrequenz kann die Induktivität geringer werden. Damit wird auch der Winkel zwischen Netz-Wechselspannung u_{N} und Stellerspannung u_{St} kleiner. Ein entsprechendes Zeigerdiagramm ist in der Veröffentlichung mit dem Titel "Vierquadrantensteller - eine netzfreundliche Einspeisung für Triebfahrzeuge mit Drehstromantrieb", Sonderdruck aus der DE-Zeitschrift "Elektrische Bahnen", Jahrgang 45, Heft 6, 1974, insbesondere dem Bild 10 dieses Sonderdrucks, dargestellt.

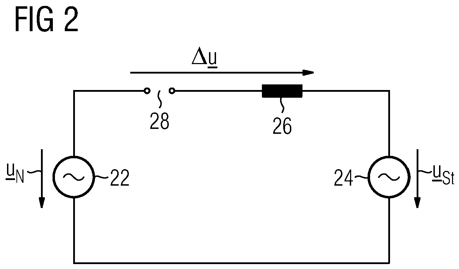

Bei den erfindungsgemäßen Verfahren zur Funktionsprüfung des Vakuumschalters 12 eines Traktionsstromrichters befinden sich die beiden Kontakte des Vakuumschalters 12 im geöffneten Zustand. D.h., diese beiden Kontakte sind zueinander beabstandet in der Vakuumkammer des Vakuumschalters 12 angeordnet. Aus diesem Grund ist dieser Vakuumschalter 12 im einphasigen Ersatzschaltbild gemäß FIG 2 als Funkenstrecke 28 dargestellt. Die Prüfspannung für den Vakuumschalter 12 entspricht der Differenzspannung Δu zwischen Netz-Wechselspannung u_{N} und Stellereingangsspannung u_{St} . Um die Funktionsfähigkeit des Vakuumschalters 12 prüfen zu können, muss diese Differenzspannung Δu einen vorbestimmten Wert einer Durchschlagsspannung erreichen. Die Amplitude der Differenzspannung Δu ist durch die zeitliche Lage der Stellereingangsspannung u_{St} relativ zur Netz-Wechselspannung u_{N} einstellbar. D.h., der Winkel zwischen der Netz-Wechselspannung u_{N} und der Stellereingangsspannung u_{St} muss einen vorbestimmten Wert erreichen. Liegt die Netz-Wechselspannung u_{N} derart zeitlich relativ zur Stellereingangsspannung u_{St}, dass die Differenzspannung Δu die Amplitude einer vorbestimmten Prüfspannung erreicht, wird der Vierquadrantensteller 2 derart angesteuert, dass als Stellereingangsspannung u_{St} ein Spannungspuls ansteht. Dieser Spannungspuls ist zeitlich so bemessen, dass der Traktionstransformator 10 nicht in Sättigung gerät. Danach wird überprüft, ob ein Strom vom speisenden Netz vom Vierquadrantensteller 2 fließt. Diese Überprüfung erfolgt mit der Messwerterfassung des Vierquadrantenstellers 2. Kann kein fließender Strom ermittelt werden, hat der Vakuumschalter 12 seine Funktionsprüfung bestanden. Kann jedoch ein fließender Strom erfasst werden, so ist der Vakuumschalter fehlerhaft und muss ausgetauscht werden.

Mit diesem erfindungsgemäßen Verfahren kann zu jeder Zeit und an jedem Ort der Vakuumschalter eines Traktionsstromrichters auf Funktionsfähigkeit geprüft werden, ohne dass dabei ein Prüfgerät mehr benötigt wird.

## Patentansprüche

1. Verfahren zur Funktionsprüfung eines Vakuumschalters (12) eines Traktionsstromrichters mit wenigstens einem netzseitigen Vierquadrantensteller (2) und einem lastseitigen Pulsstromrichter (4), die mittels eines Zwischenkreiskondensators (C_{ZK}) gleichspannungsseitig elektrisch parallel geschaltet sind, und mit einem Traktionstransformator (10) mit wenigstens einer Sekundärwicklung (8), deren Anschlüsse mit wechselspannungsseitigen Anschlüssen (16,18) des Vierquadrantenstellers (2) verknüpft sind und dessen Primärwicklung mit einem Anschluss mittels des Vakuumschalters (12) mit einer Netz-Wechselspannung (u_{N}) verbindbar ist, wobei der Vierquadrantensteller (2) bei geöffneten Vakuumschalters (12), genau dann angesteuert wird, wenn die ermittelte Netz-Wechselspannung (u_{N}) derart zeitlich relativ zur Stellereingangsspannung (u_{St}) liegt, dass eine zwischen Netz-Wechselspannung (u_{N}) und Stellereingangsspannung (u_{St}) ermittelte Differenzspannung (Δu) amplitudenmäßig einem vorbestimmten Wert einer Durchschlagsspannung entspricht, wobei anschließend überprüft wird, ob ein Strom vom speisenden Netz zum Vierquadrantensteller (2) fließt.

2. Verfahren nach Anspruch 1, **dadurch gekennzeichnet, dass** die generierte Stellereingangsspannung (u_{St}) ein Spannungspuls ist.

3. Verfahren nach Anspruch 1 oder 2, **dadurch gekennzeichnet, dass** die generierte Stellereingangsspannung (u_{St}) frei einstellbar ist.

4. Verfahren nach Anspruch 3, **dadurch gekennzeichnet, dass** die zeitliche Lage der generierten Stellereingangsspannung (u_{St}) relativ zur Netz-Wechselspannung (u_{N}) einstellbar ist.

## Claims

1. Method for functionally checking a vacuum switch (12) of a traction converter having at least one AC supply-side four-quadrant chopper (2) and a load-side pulse-controlled converter (4) which are electrically connected in parallel by means of an intermediate circuit capacitor (C_{ZK}) on the DC voltage side, and having a traction transformer (10) with at least one secondary winding (8), the terminals of which are linked to AC voltage-side terminals (16,18) of the four-quadrant chopper (2) and the primary winding of which can be connected with one terminal to an AC supply voltage (u_{N}) by means of the vacuum switch (12), wherein with the vacuum switch (12) open the four-quadrant chopper (2) is driven precisely when the measured AC supply voltage (u_{N}) is disposed relative in time to the chopper input voltage (u_{St}) such that a differential voltage (Δu) measured between AC supply voltage (u_{N}) and chopper input voltage (u_{St}) corresponds in terms of amplitude to a predetermined value of a breakdown voltage, wherein a check is subsequently carried out to determine whether a current is flowing from the feeding network to the four-quadrant chopper (2).

2. Method according to claim 1, **characterised in that** the generated chopper input voltage (u_{St}) is a voltage pulse.

3. Method according to claim 1 or 2, **characterised in that** the generated chopper input voltage (u_{St}) is freely adjustable.

4. Method according to claim 3, **characterised in that** the timing of the generated chopper input voltage (u_{St}) relative to the AC supply voltage (u_{N}) is adjustable.

## Revendications

1. Procédé de contrôle du fonctionnement d'un interrupteur (12) à vide d'un convertisseur de traction ayant au moins un régleur (2) à quatre cadrans et un convertisseur (4) d'impulsion du côté de la charge, qui sont montés en parallèle électriquement du côté de la tension continue au moyen d'un condensateur (C_{ZK}) de circuit intermédiaire et ayant un transformateur (10) de traction ayant au moins un enroulement (8) secondaire, dont les bornes sont connectées à des bornes (16, 18) du côté de la tension alternative du régleur (2) à quatre cadrans et dont l'enroulement primaire peut, par une borne au moyen de l'interrupteur (12) à vide, être relié à une tension (U_{N}) alternative du réseau, le régleur (2) à quatre cadrans étant commandé lorsque l'interrupteur (12) à vide est ouvert exactement lorsque la tension (U_{N}) alternative du réseau déterminé est telle dans le temps par rapport à la tension (U_{ST}) d'entrée du régleur qu'une différence (Δu) de tension déterminée entre une tension (U_{N}) alternative du réseau et une tension (U_{ST}) d'entrée du régleur correspond en amplitude à une valeur définie à l'avance d'une tension de claquage, dans lequel ensuite on contrôle si un courant passe du réseau d'alimentation au régleur (2) à quatre cadrans.

2. Procédé suivant la revendication 1, **caractérisé en ce que** la tension (U_{St}) d'entrée du régleur produite est une impulsion de tension.

3. Procédé suivant les revendications 1 ou 2, **caractérisé en ce que** la tension (U_{St}) d'entrée du régleur produite peut être réglée à volonté.

4. Procédé suivant la revendication 3, **caractérisé en ce que** la position dans le temps de la tension (U_{St}) d'entrée du régleur produite est réglable par rapport à la tension (U_{N}) alternative du réseau.
